# EUROPEAN PATENT SPECIFICATION

(11) **EP 0 459 763 B1**
(45) Date of publication and mention of the grant of the patent: **02.05.1997**
(21) Application number: 91304819.5
(22) Date of filing: 29.05.1991
(51) Int. Cl.: H01L 29/786, H01L 29/49

(54) **Thin-film transistors**
Dünnfilmtransistoren
Transistors en couche mince

(30) Priority: 29.05.1990 JP 140580/90; 29.10.1990 JP 293264/90
(43) Date of publication of application: 04.12.1991
(73) Proprietor: SEMICONDUCTOR ENERGY LABORATORY CO., LTD., Atsugi-shi Kanagawa-ken, 243 (JP)
(72) Inventor: Zhang, Hongyong, Yamato-shi, Kanagawa-ken 242 (JP); Yamazaki, Shunpei, Setagaya-ku, Tokyo 157 (JP)
(74) Representative: Milhench, Howard Leslie

(56) References cited:
- FR-A- 2 573 916
- FR-A- 2 573 916
- PATENT ABSTRACTS OF JAPAN vol. 13, no. 226 (E-763)(3574), 25 May 1989; & JP - A - 135959 (RICOH) 07.02.1989
- idem
- JAPANESE JOURNAL OF APPLIED PHYSICS vol. 27, no. 11, November 1988, pages L2118-L2120, Tokyo, JP; T. TAKESHITA et al.: "Study of ECR Hydrogen Plasma Treatment on Poly-Si Thin Film Transistors"
- PATENT ABSTRACTS OF JAPAN vol. 11, no. 7 (E-469)(2454), 9 January 1987; & JP - A - 61183970 (MATSUSHITA ELECTRIC) 16.08.1986
- PATENT ABSTRACTS OF JAPAN vo. 11, no. 220 (E-524)(2667), 16 July 1987; & JP - A - 6239068 (SONY) 20.02.1987
- PATENT ABSTRACTS OF JAPAN vol. 12, no. 115 (E-599)(2962), 12 April 1988; & JP - A - 62244165 (NEC) 24.10.1987
- PATENT ABSTRACTS OF JAPAN vol. 14, no. 257 (E-936)(4200), 4 June 1990; & JP - A - 277127 (SONY) 16.03.1990

## Description

### Field of the Invention

This invention relates generally to thin-film transistors (hereinafter referred to as TFTs) and particularly, though not exclusively concerns TFTs made of non-single-crystal semiconductor, for example IG-FETs, and relates also to their manufacturing processes. The invention has particular, though not exclusive, application to a highly reliable thin-film transistor which is suitable for use as a driving element of a display image sensor or liquid crystal device or the like.

### Background of the Invention

Thin-film transistors can be formed by a chemical vapor deposition method on an insulated substrate in a comparatively low temperature atmosphere, with a maximum temperature of 500°C, the substrate being made for example of an inexpensive material such as soda glass or borosilicate glass.

Such a thin-film transistor may be configured as a field-effect transistor and can have the same features as a MOSFET. In addition, as mentioned above, it has the advantage that it can be formed on an inexpensive insulated substrate at a low temperature. Also thin film transistors can be formed on a large substrate by the use of CVD techniques. They therefore offer very good prospects for use as switching elements of a matrix type liquid crystal display having a lot of picture elements, or as switching elements of a one-dimensional or two-dimensional image sensor.

Also, thin-film transistors can be formed using already established photolithography technology, by means of which very minute processes are possible, and can be integrated just as in the manufacture of an IC and so on.

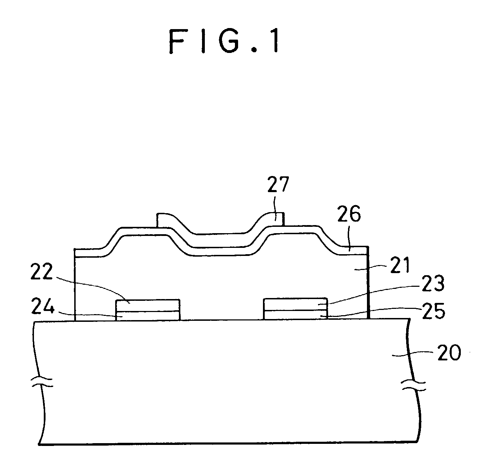

Fig. 1 of the accompanying drawings shows the construction of a typical prior art TFT. In Fig. 1, the thin-film transistor comprises an insulating substrate 20 made of glass, a semiconductor thin film 21 made of a non-single-crystal semiconductor, a source region 22, a drain region 23, a source electrode 24, a drain electrode 25, a gate insulating film 26, and a gate electrode 27.

In this type of thin-film transistor, the current flow between the source 22 and the drain 23 is controlled by applying a voltage to the gate electrode 27. The response speed of the thin-film transistor is given by the equation:${\text{S = µ.V/L}}^{\text{2}}$ where L is the channel length, µ is the carrier mobility, and V is the gate voltage.

In this type of thin-film transistor, the non-single-crystal semiconductor layer contains many grain boundaries. Non-single-crystal semiconductor, as compared to single-crystal semiconductor, has disadvantages in that due to the many grain boundaries the carrier mobility is very low and thus the response speed of the transistor is very slow. Especially if an amorphous silicon semiconductor is used, the carrier mobility is only about 0.1 - 1 (cm²/V.sec) and is too low to function as a TFT.

It is obvious that to solve this problem the channel length needs to be shortened and the carrier mobility increased. Many improvements are being made towards these ends.

When the channel length L is decreased, the effect on the response speed is as the square of the channel length, and so reduction in channel length is a very effective means of increasing response speed. However, when forming elements on a large area substrate, it is difficult to use photolithography techniques to obtain a spacing between the source and drain regions (this spacing being essentially the channel length) of 10 µm or less, due to limitations of the precise process and to yield and manufacturing cost problems. Consequently, effective means for shortening the channel length of such a TFT have not as yet been found.

On the other hand, to increase the mobility (µ) of the semiconductor layer. single-crystal semiconductor or poly-crystal semiconductor material may be used, and when using amorphous semiconductor material, the active region of the TFT should be crystallized after the semiconductor is formed using a process such as heat treatment.

In this case, a temperature higher than that normally required to form a-Si is necessary. For example:
(1) For a thin-film transistor made of amorphous semiconductor material, the amorphous silicon film is made at a temperature of about 250°C and then a maximum temperature of 400°C is required for thermal annealing;
(2) When a poly-crystal silicon film is formed by a low pressure CVD method, the maximum temperature required for forming the film and then for recrystallization is 500 to 650°C;
(3) For a thin-film transistor where only an active layer is converted to poly-crystalline structure, the required CVD temperature for forming the semiconductor layer is 250 to 450°C, however the temperature exceeds 600°C during a recrystallization of the active layer by CW laser.

TFTs are commonly formed on a substrate made of a material such as soda glass and the active region of the TFT comes into direct contact with the glass substrate, especially in the case of stagger-type and coplanar-type transistors. When making a TFT that has sufficiently fast response speed, heat treatment as mentioned above is necessary and so the metallic alkali impurities such as sodium and potassium which exist in the glass substrate are externally diffused and forced into the semiconductor layer which forms the active layer of the TFT. This lowers the mobility of the semiconductor layer and changes the threshold value, making the characteristics of the device worse and having an adverse effect on the long-term reliability of the device.

Also, through operation of a TFT, the TFT produces heat which causes the temperature of the glass substrate to rise thus causing impurities to be diffused from the substrate, which also has an adverse effect on the TFT.

Generally, a gate-insulator of an IG-FET is made of a silicon oxide film which is formed by a sputtering method with argon (Ar) gas used as a sputtering gas. In the sputtering process, the argon atoms are inherently introduced into the gate insulator and generate a fixed charge in the semiconductor film. Also, ions that exist in the reaction space during sputtering collide with the surface of the active layer of the thin-film transistor and this causes damage to the active layer. As a result, a mixed layer of active and insulating material is formed at the boundary region between the gate insulation layer and the active layer of the transistor. In producing a TFT as described above, the problems of response speed and reliability still need to be solved.

There are a number of prior art document relating to TFTs. In JP-A-61-183970 (corresponding to the preamble of claim 1), an Si nitride thin film is formed over a glass substrate, under the gate electrode of a TFT. The gate electrode is covered by a further insulating Si nitride thin film. Such sandwiching of the gate electrode is stated to relieve stress and prevent the diffusion of alkali ions present in the glass substrate. JP-A-62-39068 teaches placing an SiO₂ film as a buffer layer between a glass substrate and a single crystal silicon TFT. On the other hand, JP-A-1-35959 discloses a TFT wherein the gate insulating film is SiO₂ film formed by a deposition method and annealed in an oxygen atmosphere containing halogen atoms. The TFT is formed on an insulating substrate of quartz, pyrex or the like. In the reference T. Takeshita et al.: Japanese Journal of Applied Physics, Vol. 27, No. 11 (1988), pages L2118-L2120, a TFT is formed by thermally growing an oxide layer on a P-type silicon wafer. The TFT is then formed above the oxide layer, including a poly-Si layer in the channel region of the transistor.

### Objects and Summary of the Invention

It would be desirable to produce a high speed TFT which uses non-single-crystal-semiconductor, and to solve or at least substantially reduce the problems of reliability mentioned above.

The present invention is set out in the appended claims.

The invention in one embodiment provides that a halogen doped insulation layer 50nm (500 angstrom) to 500nm (5000 angstrom) thick is formed on the glass substrate as a bottom protective film before the TFT elements are formed, and the TFT elements are formed on top of this protective film. By means of such a structure, it is possible to keep impurities existing in the glass substrate from going into the active layer of the thin-film transistor or into the transistor elements themselves, and to provide a thin-film transistor that has high mutual conductance and high field-effect mobility. Also the diffusion of impurities from the substrate, which tended to occur when heat is generated during operation of the device, is suppressed. Furthermore, in a thin-film transistor according to the invention degeneration of the electrical characteristics of the transistor can be controlled giving long-term stability and reliability.

The invention provides furthermore for the addition of a halogen element to the protective film, whereby impurities intruding from outside or impurities in the film can be neutralized. Interface states between the insulation layer and the semiconductor layer can also be reduced by the halogen element. This increases stability and reliability of the TFT.

The above and further aspects of the invention are set forth with particularity in the appended claims and will best be understood from consideration of the following detailed description given with reference to the accompanying drawings.

### Brief Description of the Drawings

Fig. 1 shows a cross sectional view of part of a prior art thin-film transistor;
Figs. 2(A) to 2(C) show the manufacturing process of a thin-film transistor in accordance with a first example useful for understanding the present invention;
Figs. 3(A) to 3(C) show the manufacturing process of a thin-film transistor in accordance with a second example useful for understanding the present invention;
Figs. 4(A) to 4(D) show the manufacturing process of a thin-film transistor in accordance with an embodiment of the present invention;
Fig. 5 is a graph showing the relationship between the flatband voltage of an insulation film formed by a sputtering method and the percentage of argon in the sputtering gas;
Fig. 6 is a graph showing the relationship between the flatband voltage of an insulation film formed by a sputtering method and the percentage of fluoride gas in the sputtering gas;
Fig. 7 is a graph showing the relationship between the withstand voltage of an insulation film formed by a sputtering method and the percentage of fluoride gas in the sputtering gas;
Fig. 8 is a graph showing the relationship between the mobility of a non-single-crystal semiconductor formed by a sputtering method and the partial pressure of hydrogen in the sputtering gas:
Fig. 9 shows the relationship between the partial pressure of hydrogen in the sputtering gas and the threshold voltage:
Figs. 10 to 14 show TFT source current and source voltage characteristics; and
Fig. 15 shows a Raman spectrogram of a semiconductor layer formed in accordance with the present invention;

### Detailed Description

### Example 1

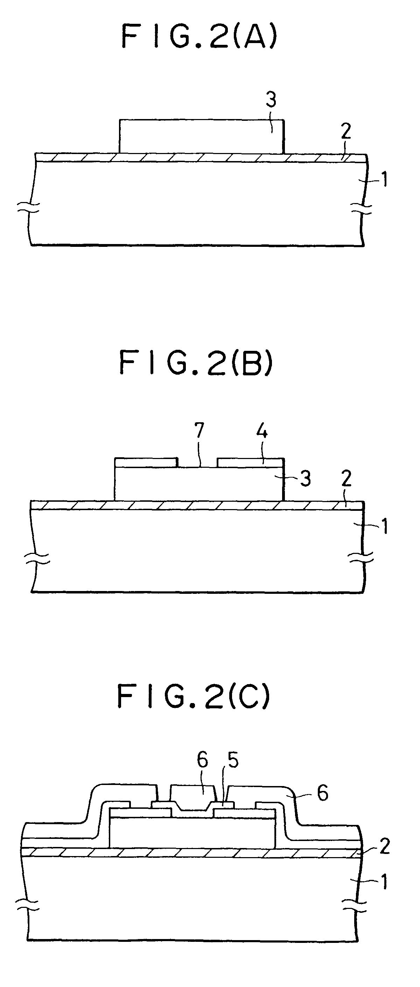

The manufacturing process of a planar type thin-film transistor in accordance with a first example useful for understanding the present invention is shown in Figs. 2(A) to 2(C).

First a glass substrate 1 is made of soda glass and on an entire surface of the substrate 1, a 300 nm thick silicon oxide bottom protective film 2 is formed by sputtering. The formation conditions of the film are shown below.

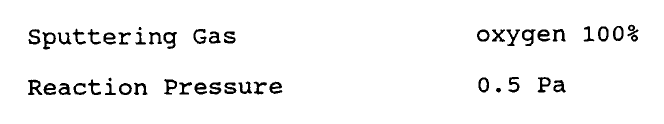

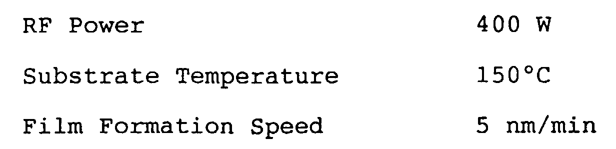

Next, an approximately 100 nm thick I-type conductivity non-single-crystal silicon semiconductor film 3 is formed by a CVD method on the protective film 2. The manufacturing conditions are shown below.

| | |
|---|---|
| Substrate Temperature | 300°C |
| Reaction Pressure | 6.66 Pa (0.05 Torr) |
| Rf Power (13.56 MHz) | 80 W |
| Gas Used | SiH₄ |

After this, a predetermined etching step is performed so that the structure shown in Fig. 2(A) is obtained.

Next, in at least one region of the semiconductor film 3 an active layer is formed using an excimer laser to perform laser annealing to promote polycrystallization. The conditions are as follows.

| | |
|---|---|
| Laser energy density | 200 mJ/cm² |
| Number of Irradiation Shots | 50 |

Then a non-single-crystalline silicon layer 4 which has an N-type conductivity is formed on the above structure by a CVD method as a low resistance non-single-crystal semiconductor layer. The formation conditions are as follows.

| | |
|---|---|
| Substrate Temperature | 220°C |
| Reaction Pressure | 6.66 Pa (0.05 Torr) |
| Rf Power (13.56 MHz) | 120 W |
| Gas Used | SiH₄ + PH₃ |
| Film Thickness | 150 nm (1500 angstrom) |

When making this N-type non-single-crystal silicon semiconductor layer 4, a large quantity of H₂ gas can be used and the RF power can be increased to form micro-crystals which lowers the electrical resistance.

Then, a part of the N-type semiconductor layer 4 is etched by photolithography so that it is patterned into source and drain regions 4 and a channel region 7 is defined therebetween as shown in Fig. 2B.

After that, hydrogen plasma processing is performed under the following conditions to activate the channel region 7.

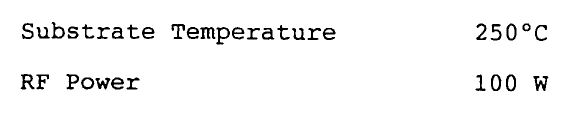

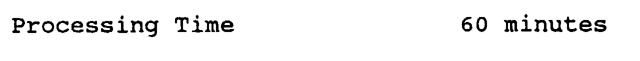

On top of the structure shown in Fig. 2B, a 100 nm thick gate insulation film 5 is formed using the same material and the same method as was used for forming the bottom protective film 2. The contact holes for the source and drain regions are formed using an etching method and then the source, drain, and gate electrodes 6 are formed using aluminum. By means of the above process, the IG-FET shown in Fig. 2(C) is formed.

In this example, the gate insulation film 5 and the bottom protective film 2 are made of the same material and are formed using the same method. Therefore, during heat treatment of the thin-film transistor or when heat is generated during operation of the transistor, there is no difference between in the heat expansion of the two and so there is no breakage or peeling of the aluminum or metal electrodes, giving the transistor long-term reliability.

### Example 2

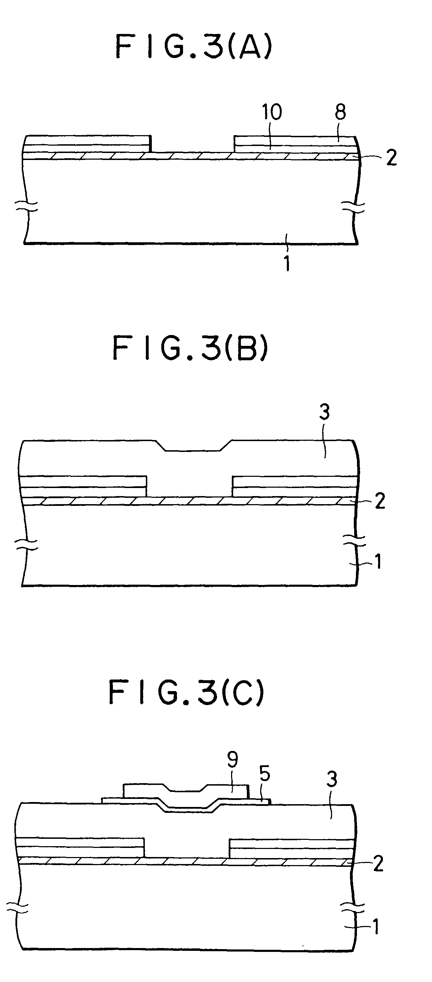

Figs. 3A to 3C show the manufacturing process of an IG-FET in accordance with a second example useful for understanding the present invention. First, a 50 nm (500 angstrom) to 500nm (5000 angstrom) thick silicon oxide film 2 is formed by a sputtering method on top of a soda glass substrate 1 as a protective film in a same manner as in Embodiment 1. Next, on the bottom protective film 2, a 200 nm thick molybdenum metallic layer 10 is formed. Formed on top of this structure is a non-single-crystal silicon film 8 which has P-type conductivity and has low resistance. The formation conditions this time are as follows.

| | |
|---|---|
| Substrate Temperature | 230°C |
| Reaction Pressure | 6.66 Pa (0.05 Torr) |
| Rf Power (13.56 MHz) | 150 W |
| Gas Used | Si₄ + B₂H₆ |
| Film Thickness | 20 nm (200 angstrom) |

This semiconductor layer can have ohmic contact with the I-type semiconductor layer that will be formed later in the process.

Next, a predetermined pattern is etched, and the structure shown in Fig. 3(A) is obtained. On top of this structure, a 200 nm thick I-type non-single-crystal silicon semiconductor film 3 is formed by a sputtering method. The formation conditions are as follows.

| | |
|---|---|
| Substrate Temperature | 250°C |
| Reaction Pressure | 0.2 Pa |
| Rf Power (13.56 MHz) | 80 W |
| Gas Used | Ar |

Then, using the same process as described in Embodiment 1, the I-type semiconductor layer 3 is heat treated causing polycrystallization and using a hydrogen plasma process it is activated and the structure shown in Fig. 3(B) is obtained.

Further, SiO₂ is formed by sputtering to a thickness of 100 nm to constitute a gate insulator 5, in the same manner as in Embodiment 1, after which molybdenum gate electrode 9 is formed in a predetermined pattern. Thus a thin-film transistor is formed as shown in Fig. 3(C).

In this example, because there is a metallic electrode underneath the low resistance semiconductor layer 8, the wire resistance is very low. For a TFT that is used as a switching element in a large area liquid crystal device, if the wire resistance is low, the drive signal waveform is not distorted and the liquid crystal device can be driven at high speed.

The silicon oxide film of this embodiment is formed using a sputtering method but may also be formed using photo CVD, plasma CVD, or thermal CVD.

### Embodiment of the Invention

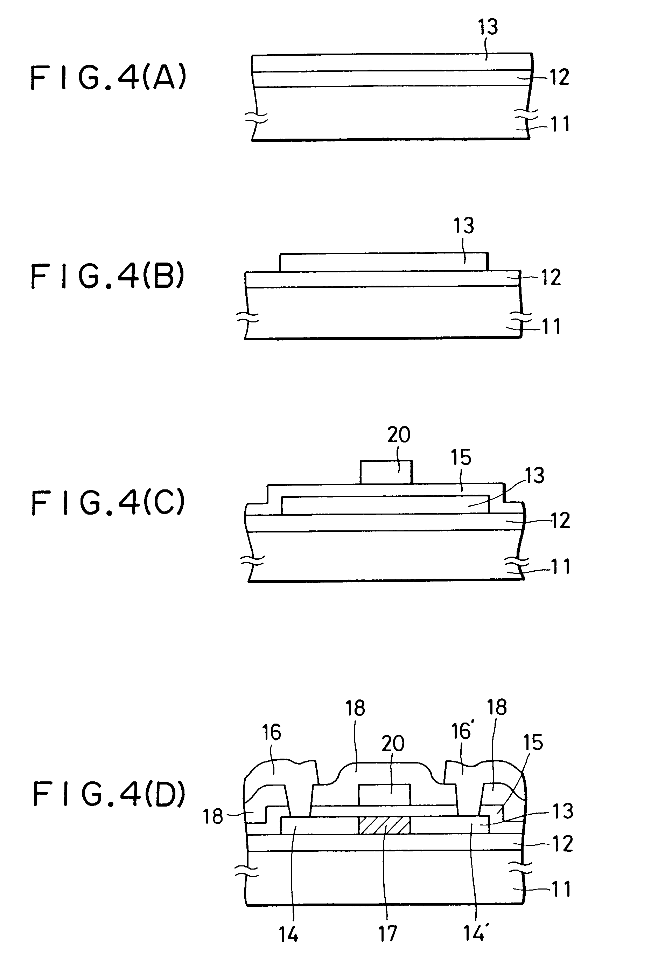

An embodiment of the present invention will be explained with reference to Figs. 4(A) to 4(D). In this embodiment a halogen element is added to the protective film on the glass substrate or to the gate insulator of the IG-FET or more preferably to both.

In Fig. 4(A) a 200 nm thick SiO₂ film 12 is formed on a glass substrate 11 using a magnetron-type RF sputtering method with the following formation conditions.

| | |
|---|---|
| Reaction Gas | O₂ 95% volume |
| | NF₃ 5% volume |
| Film Formation Temperature | 150°C |
| RF Power (13.56 MHz) | 400 W |
| Pressure | 0.5 Pa |

Silicon is used as a target.

On top of this film 12, a 100 nm thick a-Si film 13 is formed by magnetron RF sputtering in order to form a channel region, so that the structure shown in Fig. 4(A) is obtained. The film formation is done in an atmosphere of inert gas of argon and hydrogen and with the conditions shown below.${\text{H}}_{\text{2}} {\text{/(H}}_{\text{2}} \text{+ Ar) = 80%}$ (partial pressure ratio) Film

| | |
|---|---|
| Formation Temperature | 150°C |
| RF Power (13.56 MHz) | 400 W |
| Total Pressure | 0.5 Pa |

Single crystal silicon is used as the target.

After this, at a temperature of between 450°C and 700°C, for example 600°C, and in an atmosphere of hydrogen or inactive gas, in this embodiment 100% nitrogen is used, the a-Si film 13 is heat-crystallized for 10 hours, so that a silicon semiconductor layer having high crystallinity is obtained. If a non-single crystalline silicon target is used and the input power is lowered, the crystal size becomes smaller and the crystalline condition more dense and therefore the subsequent heat-crystallization of the film is facilitated.

Patterning is performed on this heat crystallized silicon semiconductor, and the structure shown in Fig. 4(B) is obtained. In a portion of the semiconductor layer 13, the channel defining region of the insulated-gate semiconductor will be formed.

Next, a 100 nm thick silicon oxide film (SiO₂) 15 is formed by magnetron-type RF sputtering with the following formation conditions.

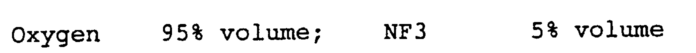

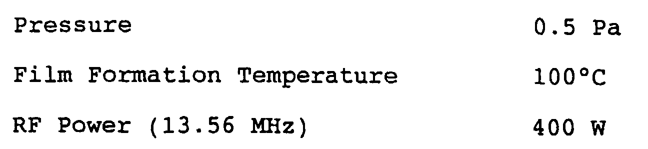

A silicon target or synthetic quartz target is used.

If an amorphous silicon target is used and the applied power is lowered, a densified silicon oxide film is obtained in which it is difficult for a fixed charge to exist.

When the silicon oxide film used in this invention, for example the gate insulation film, is formed using a sputtering method, it is preferable that the percentage of inert gasses is lower than 50% with respect to the halogen and oxide gasses, and desirably there is no inert gas.

Also, if a halogen containing gas is mixed with an oxygen containing gas at 2-20% volume, it is possible to neutralize alkali ions that are incidentally mixed into the silicon oxide film 15, and at the same time to neutralize silicon dangling bonds.

On the silicon oxide film 15 there is formed a semiconductor layer (e.g. Si) by sputtering, CVD or the like, doped with an impurity (e.g. phosphorous) for imparting a particular conductivity type thereto, following which the layer is patterned in accordance with a prescribed mask pattern so that a gate electrode 20 is formed as shown in Fig. 4C. The gate electrode 20 is not limited to being formed of a doped semiconductor and metals or other materials may also be used.

Next, using the gate electrode 20 or a mask on top of the gate electrode 20, self-aligning impurity regions 14 and 14' are formed by ion implantation. In so doing, the semiconductor layer 17 underneath the gate electrode 20 is made into a channel region of the insulated-gate type semiconductor device.

After an insulating layer 18 is formed to cover the entire surface of the above structure, holes are made in the layer 18 for source and drain electrode contacts and an aluminum film extending into these holes is formed by sputtering, and then by using a predetermined pattern, the source electrode 16 and the drain electrode 16' are formed whereby the insulated-gate type semiconductor device is completed.

The semiconductor layer that forms the channel region 17 and the semiconductor layers that form the source 14 and the drain 14' are made of the same material thus simplifying the manufacturing process. Also, semiconductor is crystallized in the source and drain regions as well as in the channel region, so that the carrier mobility is enhanced, which makes it possible to make an insulated-gate type semiconductor device that has good electrical characteristics.

Finally, this embodiment is completed by performing a hydrogen thermal anneal in a 100% hydrogen atmosphere, at a temperature of 375°C for 30 minutes. This hydrogen thermal anneal lowers the grain boundary potential in the poly-crystalline semiconductor thereby improving the characteristics of the device.

The size of the channel 17 of the thin-film transistor embodiment shown in Fig. 4(D) is 100 x 100 µm.

As explained in the above, in this embodiment the thin-film transistors are formed using poly-crystalline semiconductor.

For the sputtering method used in this embodiment, either RF sputtering or direct-current sputtering can be used, however, if the sputter target is made of an oxide with poor conductivity such as Si0₂, in order to maintain a constant electrical discharge, the RF magnetron sputtering method is preferred.

The oxide gas can be oxygen, ozone, or nitrous oxide, however, if ozone or oxygen is used, the silicon oxide film does not take in undesired atoms making it possible to obtain a very good insulation film, for example for the gate insulation film. Also it is easy to decompose ozone into 0 radicals and so the number of 0 radicals generated per unit area is large which contributes to an improvement in the film formation speed.

The halogen containing gas can be a fluoride gas such as nitrogen fluoride (NF₃, N₂F₄), or a hydrogen fluoride gas such as (HF), fluorine gas (F₂) or freon gas. NF₃ gas is easy to chemically decompose and to handle and its use is preferred. If a chlorine gas is used, it can be carbon chloride (CC1₄), chlorine (C1₂), or hydrogen chloride (HCl). The quantity of halogen gas, for example nitrogen fluoride, is from 2 to 20% volume with respect to the quantity of the oxide gas, for example oxygen. The halogen elements, during heat treatment, neutralize alkali ions such as sodium in the silicon oxide and have an effect on neutralizing silicon dangling bonds. However, if the quantity of the halogen elements is too large, the compound SiF₄ may be formed in the film and since this is a gas component it would lower the film quality and therefore is not desired. Normally, the quantity of halogen elements mixed into the film is from 0.1 to 5 atom % with respect to the silicon.

In forming the gate insulation film by a sputtering method as is done in the prior art, the quantity of the inert gas argon is more than oxygen. Conventionally, oxygen is from 0 to about 10% volume. In the prior art sputtering method, it is natural to think that the argon gas hits the target material, resulting in target grains being generated to form a film on the surface. This is because the probability that the argon gas will hit the target material (sputtering yield) is high. The inventors of the present invention have earnestly examined the characteristics of gate insulation films formed by the sputtering method and we found that the shift from the ideal value of flatband voltage, which reflects the number of fixed charges in the gate insulation film, and the interface states between the activation layer and the gate insulation film, indicating the gate insulation film performance, largely depends on the proportion of argon gas in sputtering. The flatband voltage is the voltage required to oppose the effect of the fixed charge in the insulation film and the lower this voltage the better are the characteristics of the insulation film.

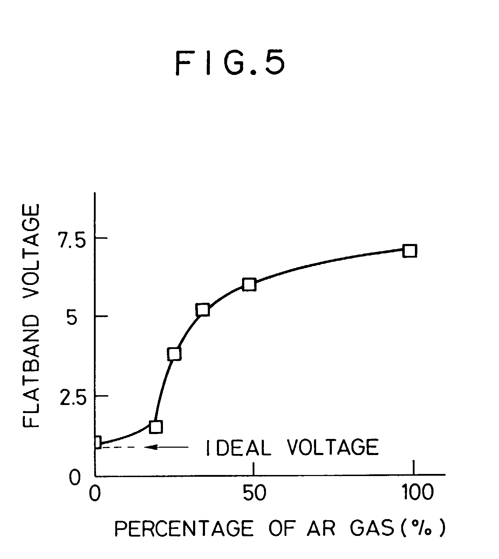

When a SiO₂ film is formed by a sputtering method on non-single-crystal semiconductor prepared in accordance with the present invention, the relationship between the proportion of argon gas with respect to oxygen and the flatband voltage is as shown in Fig. 5. The objects observed in this experiment were prepared in the following manner, namely a SiO₂ film is formed by sputtering on the poly-crystalline semiconductor layer shown in Fig. 4A and then an Al electrode is formed on it by electron beam evaporation.

When the volume of argon is less than that of oxidizing gas (oxygen in the case of Fig. 5), for example 50% or less, the flatband voltage is apparently reduced as compared to 100% argon gas. The shift from the ideal value of the flatband voltage depends largely on the proportion of argon gas. If the percentage of argon gas is less than 20%, the flatband voltage is very close to the ideal voltage. The activated argon atoms in the reactive atmosphere when forming the film by the sputtering method, have an effect on the quality of the gate insulation film, and so it is desirable in the formation of the sputtered film to reduce the amount of argon atoms as much as possible.

The reason for this is that the film formation surface is damaged by argon ions or by activated argon atoms colliding thereon, which results in the formation of interface states or fixed charges.

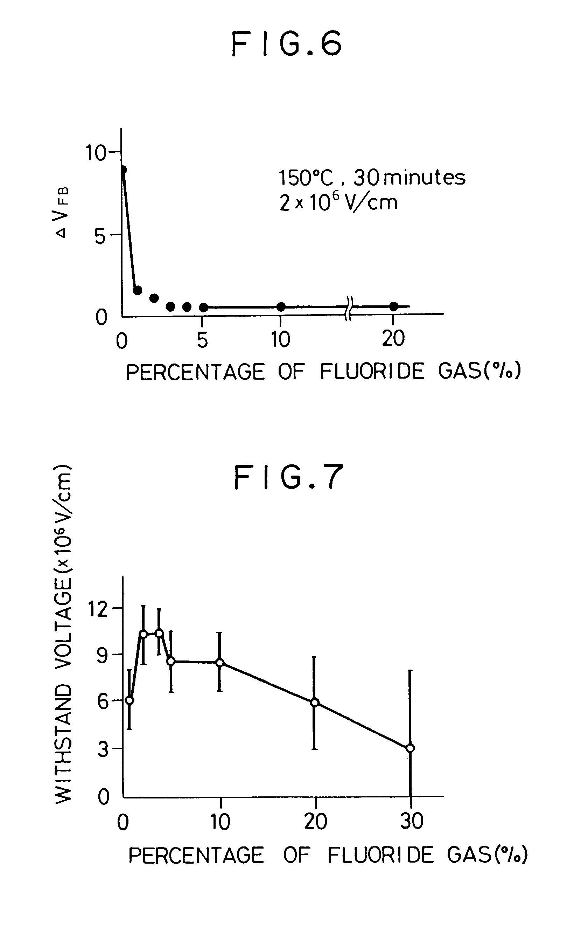

Fig. 6 shows the relationship between the shift Δ V_{FB} from the ideal flatband voltage and the percentage of fluorine with respect to oxygen in the sputtering gas (0₂/NF₃ volume %).

In an experiment, a 1 mm diameter aluminum electrode was formed on top of a silicon oxide film 15 doped with halogen elements on the poly-crystalline silicon semiconductor 13 prepared in accordance with this invention (Fig. 4A), then a thermal annealing was done at 300°C followed by a B-T (bias-temperature) process. Further a negative bias voltage of 2 x 10⁶ V/cm was applied to the gate electrode at a temperature of 150°C for 30 minutes, and then under the same conditions a positive bias voltage was applied and in this state the shift of the flatband voltage ΔV_{FB} was measured.

As can be clearly seen in Fig. 6, when silicon oxide was formed by a magnetron RF-sputtering in an atmosphere in which NF₃ is 0%, ΔV_{FB} was as much as 9V. However, if just a few halogen elements such as fluorine are added during film formation, this value is sharply reduced. This is because the positive sodium ions contaminating the film during formation combine with the fluorine and are neutralized as follows: ${\text{Na}}^{\text{+}} {\text{+ F}}^{\text{-}} \text{→ NaF}$${\text{Si}}^{\text{+}} {\text{+ F}}^{\text{-}} \text{→ Si - F}$

On the other hand, it is known that adding hydrogen neutralizes the silicon, however, the Si-H bond is likely to be separated again by a strong electric field (BT processing) and causes silicon dangling bonds and causes boundary levels to be formed, and so it is preferred to use fluorine for neutralization. Also, there always is a Si-H bond in the silicon oxide film. When this bond is separated again, the fluorine atoms neutralize the separated hydrogen atoms, which is effective in preventing the formation of boundary levels. Moreover, due to the existence of fluorine, the hydrogen bonded to the silicon bonds also with the fluorine, and thus the silicon prevents a fixed charge from developing.

Figure 7 shows the withstand voltage of the SiO₂ film when more fluoride gas is added. The withstand voltage is the voltage measured, using a 1mm diameter aluminum electrode, when the leakage current exceeds 1 µA. Depending on the test materials, there is disparity and so in the Figure, the value is shown by X and σ (dispersion sigma value). The withstand voltage becomes lower as the percentage of fluorine gas is increased to more than 20% and the σ value becomes larger. Therefore it is best if the added halogen element is less than 20% volume, and normally from 2 to 20% is good. Incidentally, when halogen gas was added at 1 volume % with respect to oxygen gas during the film formation, measuring by SIMS (secondary ion mass analysis), it was found that the density of halogen in the film was 2 x 10²⁰ atoms/cm³. It was found that when added simultaneously, during the sputtering method of film formation, the fluorine element is very easily taken in by the film. However, if too much is added (more than 20%), the silicon oxide film tends to become porous and degraded because of the formation of SiF₄, and as a result the withstand voltage becomes poor and very disperse.

Also, it is desired that the materials used in sputtering be highly pure. For example, a sputtering target made of 4N or more synthetic quartz, or high grade silicon as used for the LSI substrate is very much to be desired. The sputtering gas used should be very pure (5N or more), and mixing of impurities with the silicon oxide film should be avoided as much as possible.

In this embodiment, the silicon oxide film, that is to say the gate insulation film formed by sputtering in an oxygen atmosphere with fluorine added, is irradiated by an excimer laser and flash annealing is performed. As a result, halogen elements such as fluorine introduced into the film are effectively activated to neutralize silicon dangling bonds so that the cause of a fixed charge in the film is removed. By selecting a suitable excimer laser power and irradiating the film for a suitable number of shots, activation of both the above halogen element and the semiconductor layer underneath the gate insulation film can be performed simultaneously.

In the following there is provided an explanation regarding the formation of the a-Si semiconductor layer 13 in Fig. 4(A) by sputtering in an atmosphere with added hydrogen, and the subsequent heat recrystallization of the layer. As previously described, the channel formation region of this embodiment is obtained by applying heat at from 450 to 700°C, e.g. 600°C, for crystallization of the non-crystalline, i.e. amorphous or close to amorphous semiconductor (referred as a-Si herein) obtained by the described sputtering method in a hydrogen atmosphere or an inert gas atmosphere with hydrogen mixed in. The semiconductor after crystallization had an average grain diameter of about 0.5 to 40 nm (5 to 400 angstrom,) and the quantity of hydrogen mixed in with the semiconductor film was 5 atom % or less. Also, the crystals of this semiconductor had a distorted lattice and the boundaries of all of the crystal grains were bonded tightly from a microscopic view point, and the barriers to the carriers in the boundary regions were substantially eliminated. In a conventional poly-crystalline semiconductor without a distorted lattice, impurities such as oxygen tend to separate at grain boundaries, which forms barriers against carriers, however, in the present invention, these barriers are substantially eliminated by virtue of the distorted lattice and the mobility of electrons is from 5 - 300 cm²/V.s, which is very desirable.

Furthermore, in a semiconductor film obtained through a plasma CVD method, the proportion of amorphous elements is large. Portions of this amorphous element tends to be oxidized naturally and the inside of the semiconductor is thus oxidized. On the other hand, a sputtered film is very dense and natural oxidation does not advance inside of the semiconductor film, only the surface and a region very close to the surface are oxidized. This densified micro-structure makes it possible for the distorted lattice crystal grains to be pressed up very close together, which does not allow an energy barrier against carriers to be formed along the crystal grain boundaries.

Using SIMS analysis, the quantity of oxygen impurities in the semiconductor film formed by this method was found to be 2 x 10²⁰ atoms.cm⁻³ the quantity of carbon was 5 x 10¹⁸ atoms.cm^{-3,} and the quantity of hydrogen mixed in was less than 5%. The concentration value of the impurities measured using the SIMS method was taken in the direction of the depth of the semiconductor, and because the concentration changes in that direction, the values recorded are the minimum values in that direction. The reason for this is thought to be the naturally oxidized film on or very close to the surface of the semiconductor film. The concentration value of the impurities did not change even after crystallization took place.

It is of course preferable if the concentration of impurities is as low as possible for forming semiconductor devices, however, in the case of the present invention, even if oxygen is included in the semiconductor at 2 x 10²⁰ atoms.cm⁻³, the properties of the semiconductor, such as its carrier mobility, are not hindered because the semiconductor has a crystalline structure with a distorted lattice so that grain boundaries can be reduced.

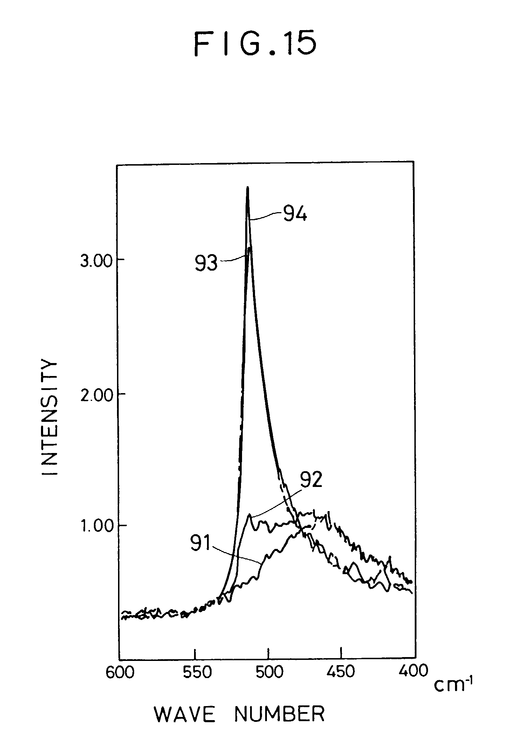

As can be seen from the laser Raman analysis data of this semiconductor film, shown in Figure 15, the peak indicating the existence of crystals is shifted to a lower wavenumber as compared to the peak of normal single crystal silicon (520cm⁻¹), thus proving the existence of a distorted lattice.

The conditions required during RF magnetron sputtering for forming the non-single-crystal semiconductor are made clear by the comparison test described below.

In order to investigate the relationship between the hydrogen partial pressure in the sputtering gas used when forming the non-single crystal silicon, and the electrical characteristics of the film, the following 6 comparison tests are performed with different hydrogen partial pressures.

| | | | | | | |
|---|---|---|---|---|---|---|
| Example number | 1 | 2 | 3 | 4 | 5 | 6 |
| Partial pressure% | 0 | 5 | 20 | 30 | 50 | 80 |

The partial pressure is calculated as the percentage of hydrogen in the total sputtering gas, H₂/(H₂ + Ar) x 100%. Test 6 corresponds to the Embodiment as shown in Figs. 4A - 4D. The other conditions of the test were substantially the same as the conditions described in the Examples as shown in Figs. 2A - 2C and 3A - 3C.

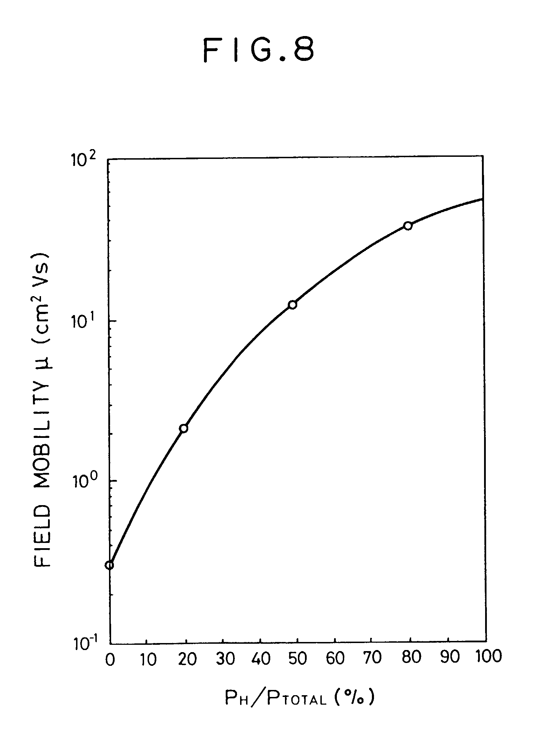

Figure 8 is a graph showing the relationship between the mobility µ of non-single-crystal silicon and the partial pressure ratio (P_{H}/P_{TOTAL} = H₂/(H₂ + Ar)) of hydrogen in the sputtering gas. According to Figure 8, it is seen that remarkably high mobility is obtained when the hydrogen partial pressure is 20% or more.

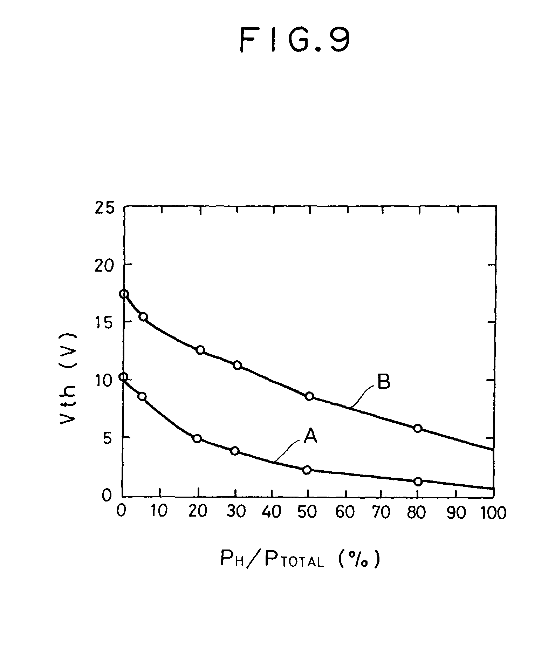

In the graph of Figure 9, curve A shows the relationship between the threshold voltage Vth and the hydrogen partial pressure ratio. Curve B is used for comparison with the construction of this invention and represents a case similar to the embodiment except that the oxidized gate film does not have fluorine mixed in.

According to Figure 9, it can be seen that when a gate insulation film with fluorine mixed in is used, as in the construction of this invention, a lower threshold voltage is obtained as compared with an insulated-gate field-effect transistor which uses a prior art gate insulation film.

The lower the threshold voltage, the lower is the voltage needed to operate the thin-film transistor and the more advantageous are the characteristics of the device. Accordingly, Figure 9 shows that with conditions of high hydrogen partial pressure in the sputtering gas, a threshold voltage of 2 V or less, in normally off condition, can be obtained. Figure 9 also shows that the higher the partial pressure of hydrogen the lower is the threshold voltage. In all of the above tests, it was found that when the a-Si film which becomes the channel formation region was formed by a sputtering method, as the hydrogen partial pressure was increased so the electrical characteristics of the device were improved.

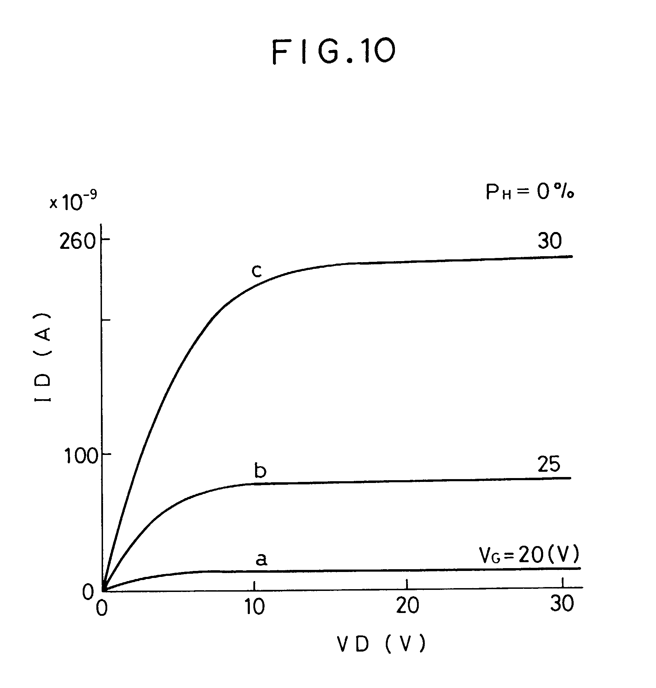

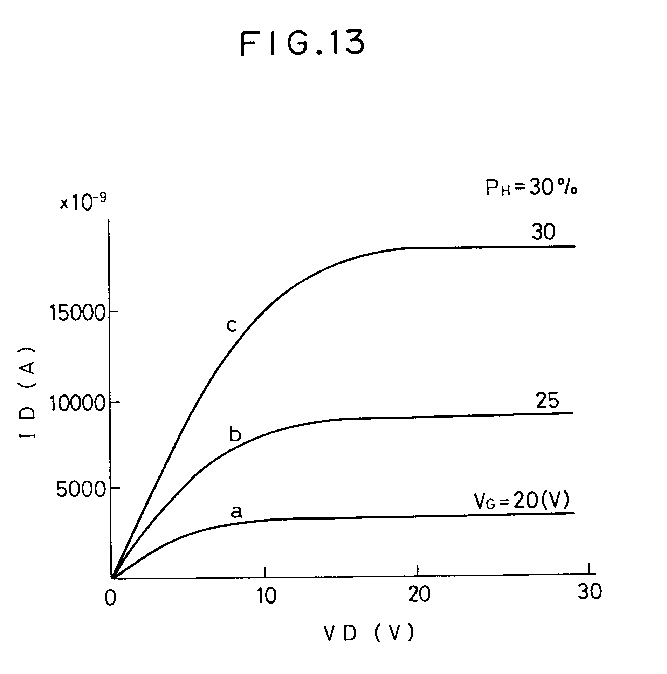

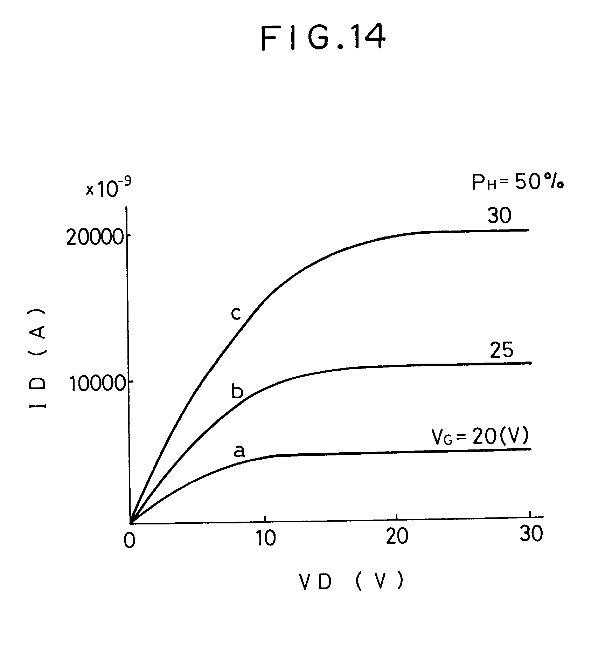

Figures 10 to 14 show the relationship between drain voltage and drain current for different gate voltages in the IG-FET formed in the comparison test described above.

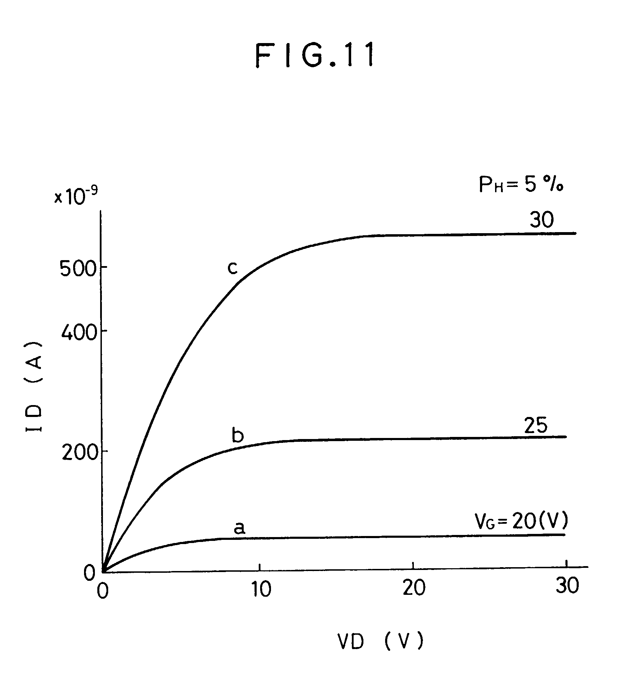

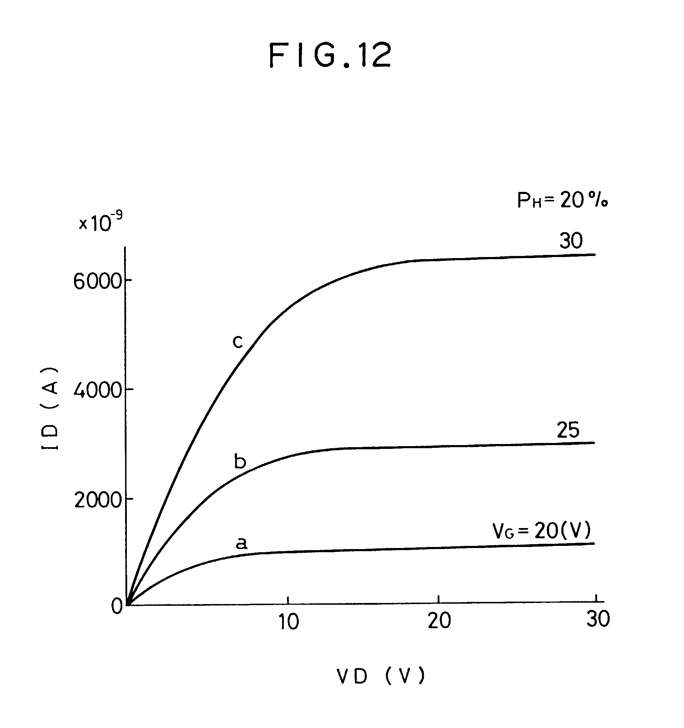

Curves a, b, and c of Figures 10 to 14 correspond to gate voltages VG of 20 V, 25 V, and 30 V. The effects of the hydrogen partial pressure can be seen by comparing Figure 11 (partial pressure 5%) and Figure 12 (partial pressure 20%). In Figures 11 and 12, when the drain currents (curve c) are compared to each other at a gate voltage of 30V, it can be seen that the drain current obtained when the hydrogen partial pressure is 20% is 10 or more times larger than when the partial pressure is 5%.

From this it can be seen that when the a-Si film 13 in Figure 4(A) is made, if the partial pressure ratio of hydrogen, added during sputtering, is increased from 5% to 20%, the electrical characteristics of the thin-film transistor are greatly improved.

Figure 15 is a Raman spectrograph of semiconductor layers of heat crystallized a-Si films with hydrogen partial pressure ratios of 0, 5, 20, and 50%. The curves 91, 92, 93, and 94 correspond to the partial pressure ratios 0, 5, 20, and 50%, respectively.

Looking at Figure 15 and comparing curve 92 with curve 93, or in other words comparing hydrogen partial pressure ratios of 5% and 20%, it can be seen that when heat crystallization is performed and the hydrogen partial pressure ratio of the sputtering gas is 20%, the Raman spectrograph remarkably shows the crystal characteristics of the silicon semiconductor.

The average diameters of the crystal grains were, from half-value width, from 0.5 to 40 nm (5 to 400 angstrom,) e.g. 5 to 30 nm (50 to 300 angstrom.) The peak position of the Raman spectrograph is shifted to the lower wavenumber side a little off from the 520 cm⁻¹ location of the single crystal silicon peak, which clearly indicates that there is distortion in the lattice. These results remarkably show the characteristics of this invention. That is, the effects of making the a-Si film using the sputtering method with hydrogen gas added, appears only when heat crystallization of the a-Si film takes place.

When the crystalline structure is distorted in the above manner, the barriers which exist at grain boundaries can be eliminated, and therefore, the carrier mobility can be improved. Also, the segregation of impurities such as oxygen at the boundaries becomes very difficult so that high carrier mobility is possible. For this reason, even if the concentration of impurities in the semiconductor film is of the order of 2 x 10²⁰ atoms.cm⁻³, no barriers against the carriers are formed, and the film can be used as the channel region of an insulated-gate semiconductor.

In comparing Figs. 12, 13, and 14, it can be seen that as the hydrogen partial pressure in the sputtering gas increases when forming the a-Si film mentioned above, the drain current becomes large. This is very clear if curves c in Figs. 12, 13, and 14 are compared to each other.

Generally, in a thin-film field-effect transistor, when the drain voltage V_{D} is low, the relationship between the drain current I_{D} and the drain voltage V_{D} is given by the following equation:${\text{I}}_{\text{D}} {\text{= (W/L)µ C (V}}_{\text{D}} {\text{- V}}_{\text{T}} {\text{)V}}_{\text{D}}$ (Solid. State electronics. Vol.24. No.11. pp.1059. 1981. Printed in Britain)

In the above equation, W is the channel width, L is the channel length, µ is the carrier mobility, C is the electrostatic capacitance of the gate oxide film, V_{G} is the gate voltage, and V_{T} is the threshold voltage. In the curves of Figs. 10 through 14 the regions near the origin are represented by the above equation (i).

If the hydrogen partial pressure is fixed, the carrier mobility µ and the threshold voltage V_{T} are fixed, and also, because W, L, and C are values that are fixed in dependence upon the structure of the thin-film transistor, the variables in equation (i) are I_{D}, V_{G}, and V_{D}. In the region near the origin of the curves shown in Figs. 10 through 14, V_{G} is fixed, and so it is seen that the curves are given by equation (i), and this equation describes the curves near the origin of Figs. 10 through 14. This is because this equation was approximately developed for when the drain voltage V_{D} is low.

According to equation (i), as the threshold voltage V_{T} is lowered and the mobility µ gets larger, the slope of the curve increases. This is clearly shown when the curves of Fig. 10 through 14 are compared based on the mobility and threshold voltages of Figs. 8 and 9.

According to equation (i), it can be seen that the electrical characteristics of the thin-film transistor depend on µ and V_{T}. Therefore, the device characteristics cannot be decided from Figs. 8 and 9 separately. When the slopes of the curves near the origin of Figs. 10 through 14 are compared to each other, it is clearly seen and concluded that it is good if the hydrogen partial pressure ratio of the sputtering gas, used when forming the a-Si film that will become the channel formation region, is 20% or more, and if possible 100%.

Data showing the effects of this invention is shown below in Table 1.

**Table 1**

| Hydrogen Partial | | | | |
|---|---|---|---|---|
| Pressure Ratio | S Value | Vth | Mobility | On/Off Ratio |
| 0 | 2.5 | 10.6 | 0.30 | 5.4 |
| 5 | 2.4 | 7.9 | 0.46 | 5.7 |
| 20 | 1.6 | 4.9 | 2.11 | 6.7 |
| 30 | 1.1 | 4.5 | 3.87 | 6.9 |
| 50 | 0.78 | 2.5 | 10.1 | 6.9 |
| 80 | 0.49 | 1.9 | 35.1 | 6.2 |

In Table 1, the hydrogen partial pressure ratio is the atmosphere condition in the magnetron RF sputtering method used when forming the a-Si film 13 of Fig. 4(A) which becomes the channel formation region 17 of Fig. 4(D) of this embodiment.

The, S value is the minimum value of [d(I_{D})/d(V_{G})]⁻¹, 1 of the initial rise slope of the curves of the graphs that show the relationship between the gate voltage (V_{G}) and the drain current (I_{D}), which describes the characteristics of the device. As this value gets smaller, the inclination of the curves showing the (V_{G} - I_{D}) characteristics becomes sharper, and the electrical characteristic of the device is high.

The on/off characteristic is the log of the minimum ratio value of the drain current which occurs at a certain gate voltage and fixed drain voltage, and the drain current when the gate voltage is varied at the same fixed drain voltage.

According to Table 1, considering everything, it can be seen that in order to obtain a high performance semiconductor using the method of this embodiment, it is adequate to employ a hydrogen partial pressure ratio of 80% or more.

This invention of this embodiment has been explained in the foregoing by reference to silicon semiconductors. However, it is possible to use germanium semiconductors, or silicon germanium semiconductor mixtures, in which case the temperature for heat crystallization can be lowered by about 100°C. A silicon-germanium mixture Si_{X}Ge_{1-X} (0 < x < 1) can be used.

Also, in forming a more densified semiconductor film or silicon oxide film in the above mentioned hydrogen atmosphere or in a hydrogen and inert gas atmosphere during sputtering, intense light or laser irradiation, of 1000 nm or less, can also be applied continuously or in pulses to the substrate or to the sputtered and flying target particles.

Also it should be clear that the present invention can be used in stagger-type, coplanar type, reverse-stagger-type, and reverse-coplanar-type insulated-gate field effect transistors.

In the above embodiment, in order to achieve Na or K neutralization, the halogen gasses such as fluorine are used. Also in the above embodiment the insulation film used is SiO₂, however, according to specific needs, alumina, tantalum oxide, barium titanate, or silicon nitride can be used in the same way.

## Claims

1. A thin film transistor formed on a substrate (11) and comprising source (14) and drain (14') regions, a channel region (17) formed between said source and drain regions, and a gate electrode (20) formed adjacent to said channel region with a gate insulator (15) therebetween, wherein a protective film (12) is formed between said transistor and said substrate (11) for preventing said transistor from being contaminated by an impurity from said substrate, characterised in that said protective film (12) is doped with a halogen.

2. The transistor of claim 1 wherein said substrate (11) comprises glass.

3. The transistor of claim 1 or 2 wherein said substrate comprises an alkali ion impurity.

4. The transistor of any preceding claim wherein said protective film (12) is from 50nm to 500nm (500 Å to 5000 Å) thick.

5. The transistor of any preceding claim wherein both of said gate insulator (15) and said protective film (12) are doped with a halogen.

6. The transistor of any preceding claim wherein said halogen comprises fluorine or chlorine.

7. The transistor of any preceding claim wherein said channel region (17) comprises a non-single crystalline semiconductor.

8. The transistor of any preceding claim wherein said channel region (17) comprises silicon.

9. The transistor of claim 8 wherein said halogen is contained at a concentration of 0.1-5 atoms % with respect to silicon.

10. The transistor of claim 8 or 9 wherein said silicon contains hydrogen at a concentration not higher than 5 atoms % with respect to silicon.

11. The transistor of any of claims 8, 9 or 10 wherein said silicon has a distorted lattice structure.

12. The transistor of claim 11 wherein said silicon contains microcrystals with a grain size in the range of from 0.5 to 40 nm (5 to 400 Å).

13. The transistor of any preceding claim wherein said protective film (12) comprises a material selected from the group consisting of silicon oxide, alumina, tantalum oxide, barium titanate and silicon nitride.

## Patentansprüche

1. Dünnfilmtransistor, ausgebildet auf einem Substrat (11) und aufweisend Source- (14) und Drain- (14') Bereiche, einen zwischen den Source- und Drain-Bereichen ausgebildeten Kanalbereich (17) und eine Gate-Elektrode (20), die an den Kanalbereich angrenzend, mit einem Gate-Isolator (15) dazwischen, ausgebildet ist, wobei eine Schutzschicht (12) zwischen dem Transistor und dem Substrat (11) ausgebildet ist, um zu verhindern, daß der Transistor durch Verunreinigungen aus dem Substrat kontaminiert wird, dadurch **gekennzeichnet**, daß die Schutzschicht (12) mit einem Halogen dotiert ist.

2. Transistor gemäß Anspruch 1, wobei das Substrat (11) Glas enthält.

3. Transistor gemäß Anspruch 1 oder 2, wobei das Substrat eine Alkaliionen-Störstelle enthält.

4. Transistor gemäß einem der vorstehenden Ansprüche, wobei die Schutzschicht (12) zwischen 50 nm und 500 nm (500 Å bis 5000 Å) dick ist.

5. Transistor gemäß einem der vorstehenden Ansprüche, wobei sowohl der Gate-Isolator (15) als auch die Schutzschicht (12) mit einem Halogen dotiert sind.

6. Transistor gemäß einem der vorstehenden Ansprüche, wobei das Halogen Fluor oder Chlor aufweist.

7. Transistor gemäß einem der vorstehenden Ansprüche, wobei der Kanalbereich (17) einen nicht-einkristallinen Halbleiter aufweist.

8. Transistor gemäß einem der vorstehenden Ansprüche, wobei der Kanalbereich (17) Silicium enthält.

9. Transistor gemäß Anspruch 8, wobei das Halogen mit einer Konzentration von 0,1 bis 5 Atom-% bezogen auf Silicium enthalten ist.

10. Transistor gemäß Anspruch 8 oder 9, wobei das Silicium Wasserstoff mit einer Konzentration von nicht mehr als 5 Atom-% bezogen auf Silicium enthält.

11. Transistor gemäß einem der Ansprüche 8, 9 oder 10, wobei das Silicium eine gestörte Gitterstruktur hat.

12. Transistor gemäß Anspruch 11, wobei das Silicium Mikrokristalle mit einer Korngröße im Bereich von 0,5 bis 40 nm (5 bis 400 Å) enthält.

13. Transistor gemäß einem der vorstehenden Ansprüche, wobei die Schutzschicht (12) Siliciumoxid, Aluminium, Tantaloxid, Bariumtitanat oder Siliciumnitrat enthält.

## Revendications

1. Transistor à couche mince formé sur un substrat (11) comprenant des régions de source (14) et de drain (14'), une région de canal (17) formée entre lesdites régions de source et de drain, et une électrode de grille (20) formée adjacente à ladite région de canal avec un isolateur de grille (15) entre la grille et la région de canal, dans lequel un film protecteur (12) est formé entre ledit transistor et ledit substrat (11) pour empêcher ledit transistor d'être contaminé par une impureté provenant dudit substrat, caractérisé en ce que ledit film protecteur (12) est dopé par un halogène.

2. Transistor selon la revendication 1, dans lequel ledit substrat (11) comprend du verre.

3. Transistor selon la revendication 1 ou 2, dans lequel ledit substrat comprend une impureté constituée par des ions alcalins.

4. Transistor selon l'une quelconque des revendications précédentes, dans lequel ledit film protecteur (12) a une épaisseur de 50 nm à 500 nm (500 Å à 5000 Å).

5. Transistor selon l'une quelconque des revendications précédentes, dans lequel l'isolateur de grille (15) et ledit film protecteur (12) sont tous deux dopés par un halogène.

6. Transistor selon l'une quelconque des revendications précédentes, dans lequel ledit halogène comprend du fluor ou du chlore.

7. Transistor selon l'une quelconque des revendications précédentes, dans lequel ladite région de canal (17) comprend un semi-conducteur non mono-cristallin.

8. Transistor selon l'une quelconque des revendications précédentes, dans lequel ladite région de canal (17) comprend du silicium.

9. Transistor selon la revendication 8, dans lequel ledit halogène est présent en une concentration de 0,1 à 5% en atome par rapport au silicium.

10. Transistor selon la revendication 8 ou 9, dans lequel ledit silicium contient de l'hydrogène à une concentration non supérieure 5 % en atomes par rapport au silicium.

11. Transistor selon l'une quelconque des revendications 8, 9 et 10, dans lequel ledit silicium a une structure en réseau déformé.

12. Transistor selon la revendication 11, dans lequel ledit silicium contient des microcristaux ayant des grains d'une dimension située dans la gamme allant de 0,5 à 40 nm (5 à 400 Å).

13. Transistor selon l'une quelconque des revendications précédentes, dans lequel ledit film protecteur (12) comprend un matériau choisi dans le groupe constitué par l'oxyde de silicium, l'alumine, l'oxyde de tantale, le titanate de baryum et le nitrure de silicium.
